Europäisches Patentamt

European Patent Office

Office européen des brevets

(11) Publication number: 0 609 964 A2

# EUROPEAN PATENT APPLICATION

(21) Application number: 94200837.6

(51) Int. Cl.5: **H03H 5/00**, H01F 21/08

(22) Date of filing: **11.04.89**

This application was filed on 29 - 03 - 1994 as a divisional application to the application mentioned under INID code 60.

(30) Priority: **11.04.88 AU 7683/88**

(43) Date of publication of application:
**10.08.94 Bulletin 94/32**

(60) Publication number of the earlier application in accordance with Art.76 EPC: **0 409 880**

(84) Designated Contracting States:
**AT BE CH DE FR GB IT LI LU NL SE**

(71) Applicant: **THE UNIVERSITY OF WESTERN AUSTRALIA**

**Nedlands, Western Australia 6009 (AU)**
Applicant: **MAGELLAN TECHNOLOGY PTY. LIMITED**
**1st Floor, 184 St. Georges Terrace**
**Perth, W.A. 6000 (AU)**

(72) Inventor: **Murdoch, Graham Alexandrer Munro**
**1st Floor, 184 St. Georges Terrace**
**Perth, Western Australia 6000 (AU)**

(74) Representative: **Newstead, Michael John et al**
**Page Hargrave**
**Temple Gate House**
**Temple Gate**
**Bristol BS1 6PL (GB)**

(54) **Adjustable reactance device and method.**

(57) The present application discloses an adjustable reactance, and a device for controlling the value of a reactance.

The invention has application in tuning circuits, and the control of electrical devices, such as electric motors.

The invention, in particular, discloses an apparatus and method for the truncation of voltage across or current through a reactance element.

The application also discloses a frequency selection device adapted to select any one of a relatively large range of frequencies.

Fig 1.

EP 0 609 964 A2

## FIELD OF INVENTION

The present invention relates to an adjustable reactance and/or device adapted to control reactance. In one form, the present device is adapted to generate, enhance and/or control oscillating currents by virtue of reactance control.

In another form of the present invention has application in tuning circuits and/or the generation and/or control of relatively high frequency currents which circulate in a tuned coil. Another application of the present invention is in the control of electric devices, such as electric motors. The present invention, however, should not be limited to only such applications.

## BACKGROUND ART

Large oscillating currents may be usefully employed in many commercial applications where their ability to generate heat, provide motive power, be converted to different impedance levels and/or be radiated for communication purposes amongst other applications, and are thus considered extremely useful. Often oscillating currents are generated and/or controlled using tuned circuits where the inductance and capacitance are tuned to resonate at or near the oscillation frequency of the generating device.

In order to facilitate the use of large high frequency currents circulating in a tuned coil, generation and/or control of them needs to be managed. To efficiently generate high frequency currents in a coil, the coil must be tuned relatively accurately to the frequency of the currents. In this way the phenomena of resonance can be used to enhance the coils efficiency and by nulling out the coils inductive reactance.

Linear tuning methods such as varicap diodes are not usable for currents above a few milliamperes or voltages above a few volts. Where currents of amps or higher are involved tuning is currently done by switching in discrete value capacitors or using large ferrite slug tuners or variable plate capacitors where servo motors control the mechanical position of the tuning elements.

Some prior art arrangements produce sub harmonics for signalling at relatively low frequencies by the synchronous switching of a circuit element in and out of the circuit for whole cycles. This, however, has not been found to be desirable nor useful in tuning a circuit.

By controlling the tuning, it has been found possible to vary the phase of currents circulating in the resonant coil.

An example application of the present adjustable reactance being used in conjunction with a tuned coil is in the application of the antenna structure disclosed in the present applicant's US patent No. 5258766. Where that antenna structure is used in the sorting of airline baggage, the passage of a metal brief case often causes the tuning coils of the antenna to become detuned. There is therefore a need to provide an apparatus which is adapted to readily retune such an antenna structure and specifically for the retuning of tuned coils.

## SUMMARY OF INVENTION

To this end, the present invention provides a reactance of predetermined or variable value in circuit by truncating voltage across or current in the reactance. Any one of a number of reactance values in a tuning element can be attained which are suitable for relatively high current/voltage tuned circuits. Duty cycle control of the truncating is preferred. Truncation within at least one portion of a signal cycle is also preferred. Synchronous truncation is a further preferred feature. The truncation may still further be provided each cycle or every second cycle or every third cycle, etc.

The present invention therefore provides a device adapted to adjust reactance of an in circuit element, said device comprising a tuning means exhibiting a non-linear VI characteristic electrically coupled to said circuit element.

The present invention also provides a variable reactance device comprising:

a reactance element; and

a truncation means coupled to said reactance element, said truncation means serving to effect voltage or current conditions associated with the reactance element.

Furthermore, the present invention provides a tuning element useful in relatively high current/voltage tuned circuits and adapted to provide an adjustable reactance value, said value being adjustable by duty cycle control.

Still further, the present invention provides a tuned circuit including the above element and/or device. The variable reactance element, in circuit may provide a means of frequency selection control. Where the reactance element has a number of possible values in circuit, a range of frequency selection may be controlled.

The present invention is predicated on the principle that where tuned circuits have a high Q factor they will reject harmonic currents and provide a low impedance path to circulating currents at the resonant frequency. Consequently a tuning element which exhibits a non-linear VI characteristic can function as an effective tuning element where the apparent reactance is given by the fundamental component of the VI characteristic. Harmonic components being rejected by the high Q of the resonant circuit.

Capacitors and inductors normally exhibit linear VI characteristics and have sinusoidal voltage and current curves when excited by sinusoidal currents and voltage. Importantly, if segment(s) of the voltage curves over each cycle are truncated to zero volts, or reduced, the inductor or capacitor will still exhibit an effective inductance or capacitance which will depend upon the fundamental voltage component across the inductor or capacitor.

If VF is the fundamental voltage component across the inductor/capacitor then the effective inductance Lc or capacitance Cc is given by

$$Cc = \frac{V_0}{V_F} \cdot C \qquad Lc = \frac{V_F}{V_0} \cdot L$$

where Vo is the fundamental voltage across the unmodified inductance L or capacitor C.

As a greater and greater portion of the inductors or capacitors voltage over each cycle is truncated to zero volts, or is reduced, the effective inductance Le changes in value from L to zero whereas; the effective capacitance changes in value from C to infinity. Truncation may be effected by dc control or switching. The truncation may also be effected synchronously. Defining the duty cycle as the ratio of truncated to undisturbed voltage then control of the duty cycle provides a means of linear control of inductance or capacitance. High efficiency operation at high voltages and currents is possible using low resistance semiconductor switches such as MOSFETS. These sort of devices are ideally suited to the application and need only operate as a high speed switch.

Alternatively the sharp onset of saturation in a magnetic core can be used to provide the truncation of inductor voltage to zero. A voltage fed to the core serves to vary the onset of core saturation and therefore the level of truncation. Above saturation the dynamic impedance of an inductor is very low and the inductor voltage will be nearly zero. Below saturation the voltage across the inductance will be high because of the high core inductance. Such a method is useful where very high voltages are present and semiconductor switches are insufficiently rated. A penalty of the saturation system is the losses in the core material.

In one embodiment it should be noted that the effective reactance of an inductance or capacitance can be controlled by either synchronously shorting the element or by open circuiting the element from the circuit. The duty cycle of a parallel synchronous switch which periodically shorts the capacitor or inductor should preferentially close when the voltage is zero.

Any suitable switch means may be used to either short or open circuit the element in the circuit.

A series connected synchronous switch which periodically open circuits a capacitor or inductor from the circuit should preferentially open when the current is zero.

The parallel implementation reduces the effective reactance with the closure of the switch whereas the series implementation increases the effective reactance with the opening of the switch.

By varying the opening or closing duty cycle, the effective reactance, as "seen" by the circuit or tuned coil, of the element can be varied.

For example with reference to the parallel implementation, where a switch is provided in parallel with a capacitor, when the switch is open, current flows through the capacitor, but the current bypasses the capacitor when the switch is closed. The effective value of the capacitor can be varied where the magnitude of the fundamental component of voltage cross switch is adjusted independently of the current flowing through it. Thus, by shorting the switch periodically, the fundamental component of voltage across the capacitor appears to be lower. In this way, the effective size of the capacitor appears to be larger than it actually is.

Preferred embodiments of the present invention will now be described with reference to the accompanying drawings where :

Figure 1 shows a toroid embodiment;

Figures 3, 9 and 11 show inductive embodiments; and

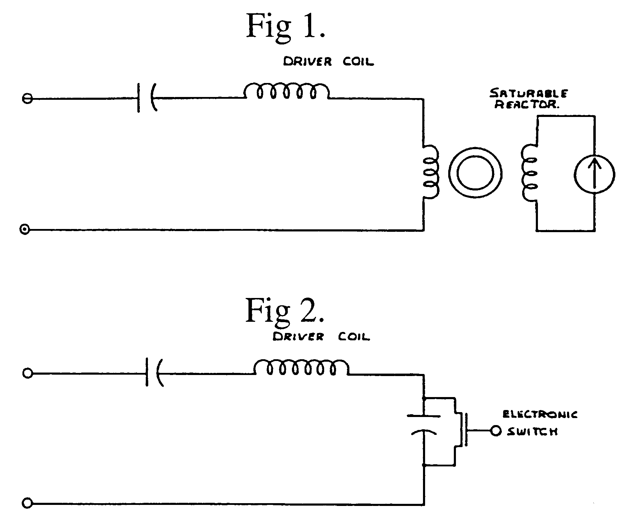

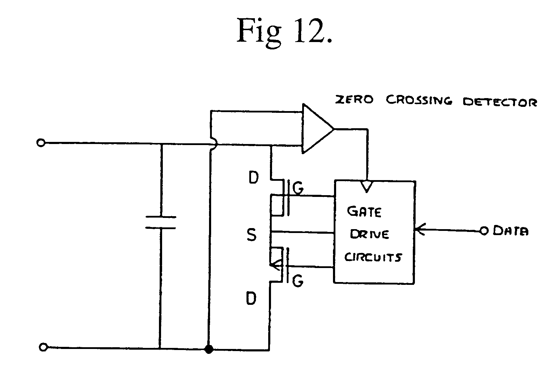

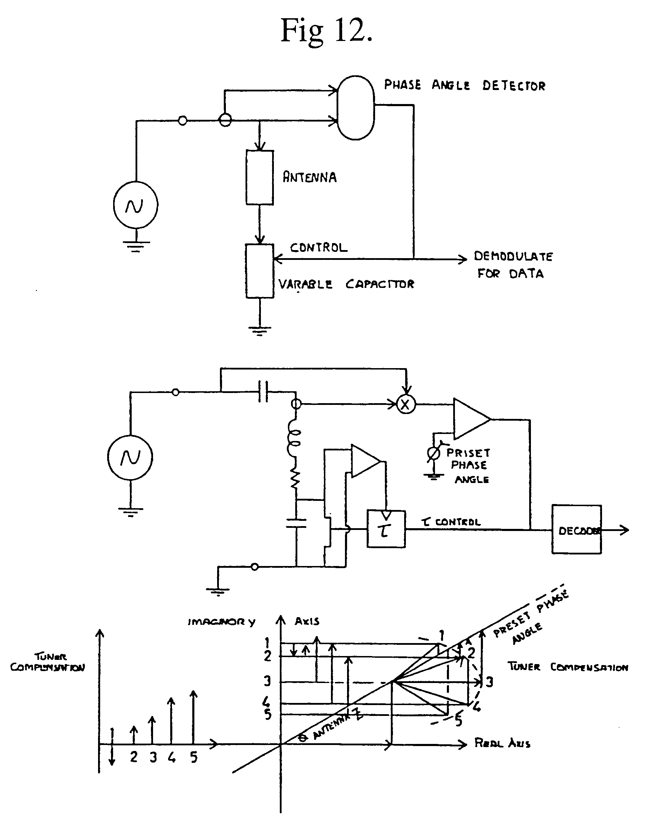

Figures 2, 4, 5, 6, 7, 8, 9, 10, 12 and 13 show capacitive embodiments.

In the embodiments referred to, the duty cycle is variable over one portion or any number of portions of each period (cycle).

In another form, the reactance element is switchable between relatively high or low Z states or shorted out.

To improve the current(s) within the coil(s), each coil pair is tuned to resonance or near resonance at an operating frequency. Accurate tuning of the coil(s) provides for more efficient operation. Control of the resonate frequency may be provided by using a variable inductor, saturable reactor or variable capacitor in series or parallel with each coil or coil pair.

The frequency and phase of the driver coil can be precisely controlled by a saturable reactor i.e. variable inductance. Part of the driver coil is wound onto a pair of high permeability toroids. A dc magnetic field is applied to each toroid. The dc field is oppositely directed in each toroid with respect to the ac field due to the driver coil current. A strong dc field will saturate the core reducing the toroid's inductance to that of an air cored toroid. By controlling the strength of the dc field the resonant frequency and phase of the driver coil can be precisely controlled (Figure 1). Alternatively, an electronically variable capacitor can be used to precisely control the phase and frequency of the driver coil current. Electronic switches connected across or in series with some of the coil's tuning capacitors, are periodically opened or closed changing the total tuning capacity of the coil's tuning capacitors. See Figure 2.

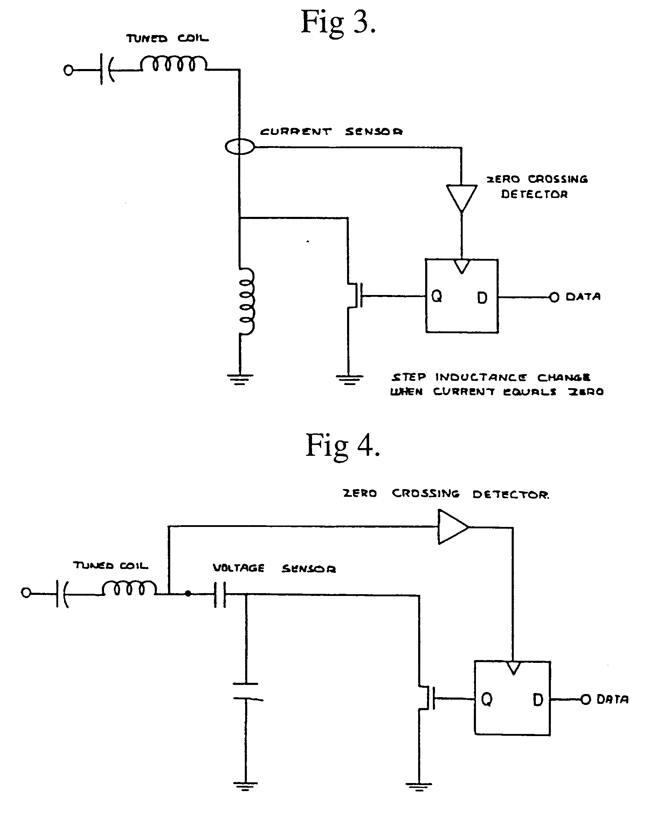

For phase or frequency modulation, the instantaneous operating frequency of the tuned coil is changed by either a step change in the coil inductance or tuning capacitance. Preferably, any step inductance change should occur when the coil current is zero while preferably any step capacitance change should occur when the capacitor voltage is zero or such that the capacitance voltage does not change when the capacitance value changes. These switching schemes serve to minimise circuit transient responses, as shown by example in Figures 3 and 4. The step change in circuit capacitance or inductance can be realised by switching a capacitor or inductor into the circuit during the whole time that the extra capacitance or inductance is required. Alternatively, the capacitor or inductor can be periodically switched in during a portion(s) of each cycle of the coil current. By varying the relative size of the portion(s) with respect to the period of a cycle, the capacitance or inductance value can be varied in similar proportion. This allows relatively accurate control of a tuned coil's resonant frequency and operating phase.

Where an interrogator is communicating with a remote device, there are two methods by which data can be signalled from the receiving unit:

(1) "Power Absorption" signalling monitors the power being absorbed by the receiving unit. Modulation of the power being absorbed by each receiving unit is detected at the base station.

(2) "Impedance Monitoring" monitors the impedance of the tuned powering coil by comparing the phase angles of the current and voltage in the tuned powering coil. The impedance can be inductively modified by the tuned coil. Modulation of the tuned coil's parameters results in modulation of the impedance of the tuned powering coil.

For both of these signalling methods the data rate is not limited by the bandwidth of the powering coil and is substantially not limited by the tuned coil's bandwidth.

Impedance monitoring measures both the real and the reactive current and voltage components in the interrogator antenna i.e. the in-phase and quadrature components. From this information a measure of the transponders tuned circuit's current magnitude and phase angle with respect to the magnetic field is constructed. Data is used to modulate the magnitude and/or phase angle of this current.

The tuned coil is tuned to, or close to, the same frequency as the inductive powering field. The total impedance of the tuned powering coils is a function of the powering coil's impedance, the mutual coupling between these two coils, the tuned coil's inductance and tuning capacitance, the circuit losses in the receiving unit, and the operating frequency. Varying any of these parameters will change the total impedance of the powering coil. The most readily varied parameter is the tuned coil's tuning capacitor. Changing the tuning capacitance changes the impedance of the powering coil and by correctly synchronising these changes, transients normally associated with these changes can be substantially eliminated. The total impedance of the powering coil shifts to the new steady state impedance as rapidly as the tuned coil does. With correct synchronisation this is nearly instantaneous.

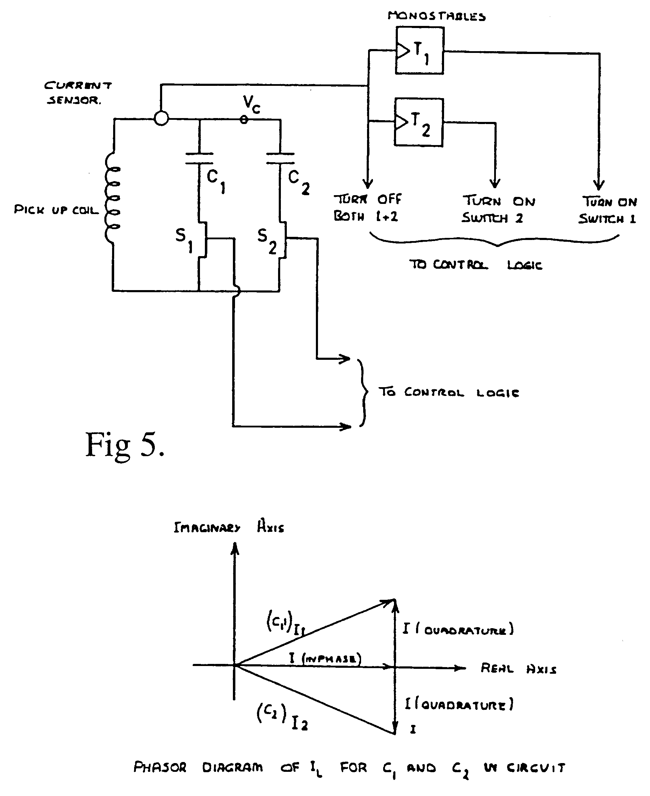

An example of a circuit for the correct synchronisation of the capacitance change is shown in Figure 5. The tuning capacitors C1 and C2 are such that C1 tunes the tuned coil to one phase angle while C2 tunes the tuned coil to a different phase angle. S1 and S2 are switches which when both opened, deactivate the tuned coil. At any time only one switch is ever closed. The switches are opened while the coil current $I_L$ is zero in exactly the same manner as the "Power Absorption" signalling hereinbefore described. Reclosure of the appropriate switch is dictated by the appropriate steady state phase angle of the system after closure. The time of reclosure is such that the resulting current flow is in phase with the steady state current flow for the particular switch.

The switched capacitors behave like two separate "Power Absorption" transmitters with the energy stored in the system being cycled between the tuned coil and the appropriate capacitor and then being stored on that capacitor while the other capacitor is switched in. A phase sensor, not shown in Figure 5, would control the points at which the capacitor switches would be reclosed.

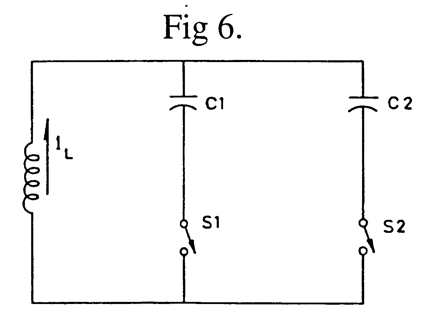

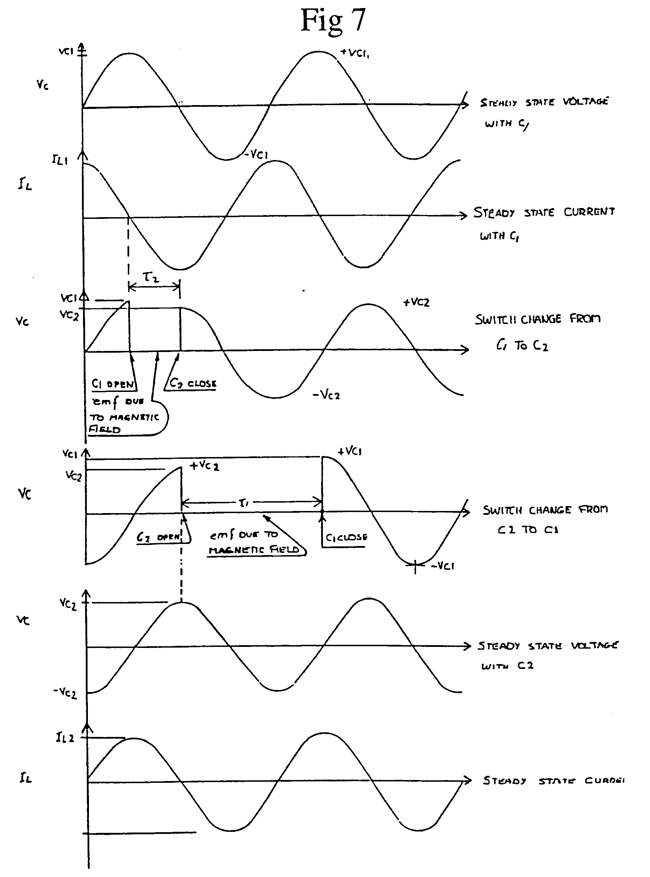

This phase sensor could be a variable delay monostable, designed to reclose the respective switch at the appropriate instant i.e. that instant when the coil current is zero in the steady state and the resultant current flow is properly in phase. Figure 6 shows an example of such a circuit. Normally there is a transient associated with any change is circuit parameters or stored energy. However here each capacitor is charged up with exactly the correct amount of energy for the respective operating conditions of the tuned coil. Upon reclosure at the proper instant the tuned system immediately establishes its steady state conditions with negligible circuit transients. Stray or parasitic circuit elements will contribute to some minor circuit transients. Figure 7 shows example waveforms for the circuit shown in Figure 6.

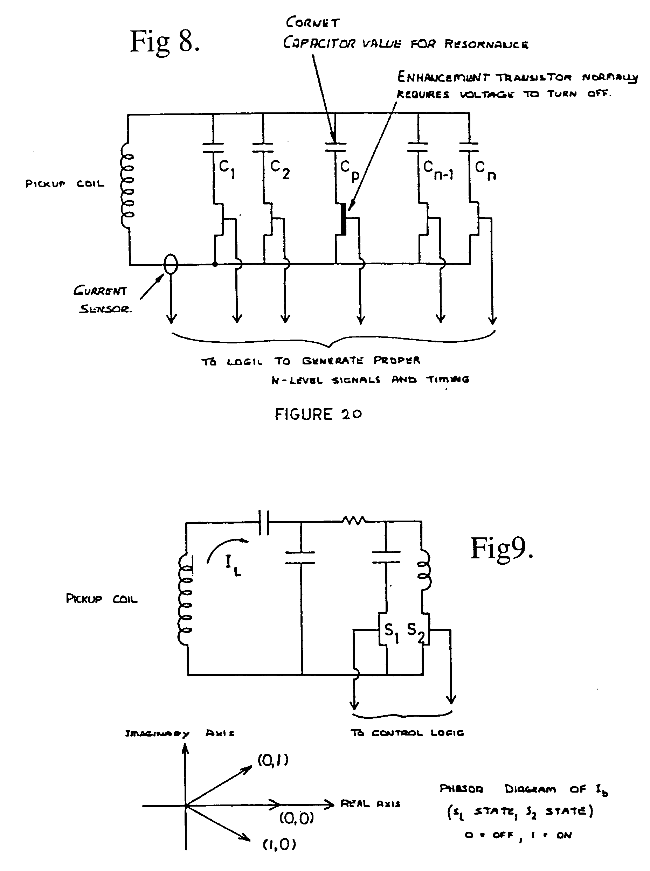

This switched capacitor system can be expanded to include a multiple of capacitors for multi-level signalling wherein the transition to the new operating condition occurs within a cycle (Figure 8). Such a system not only possesses an exceptionally high switching rate (baud rate) not limited by the bandwidth of the tuned circuit but given by:

$$BR = 3.32 \ B \log \mu$$

where BR, B and $\mu$ are the bit rate, the baud rate and the number of levels respectively. By way of example a four (4) level signalling scheme doubles the bit rate.

For the switched capacitor circuits one of the switches can preferably be a depletion transistor such that it is normally conducting and allows the tuned circuit to function normally when the magnetic powering field is first applied. The capacitor associated with this transistor preferably can be the capacitor required for perfect tuning of the tuned coil. This ensures the system collects the maximum power possible during power up and/or when no modulation is being sent (see Figure 8).

If transient settling times associated with the tuned coil's bandwidth are tolerable then modulating the tuning reactance, synchronously preferably, with data will modulate the phase and amplitude of the tuned coil's current. A transient will occur because the steady state energy stored in the tuned circuit varies with the reactance. Inductors or capacitors can be switched into the tuned circuit to vary the phase/amplitude of the tuned coil current. The bandwidth can be artificially widened by inserting extra resistance (lowering the Q) into the tuned system. Synchronous switching is preferable but not essential (see Figure 9). Multi-level signalling can be realised by paralleling a series of switched reactances. However, where transients are tolerable there is a much more efficient method of controlling the phase angle of the tuned coil's current.

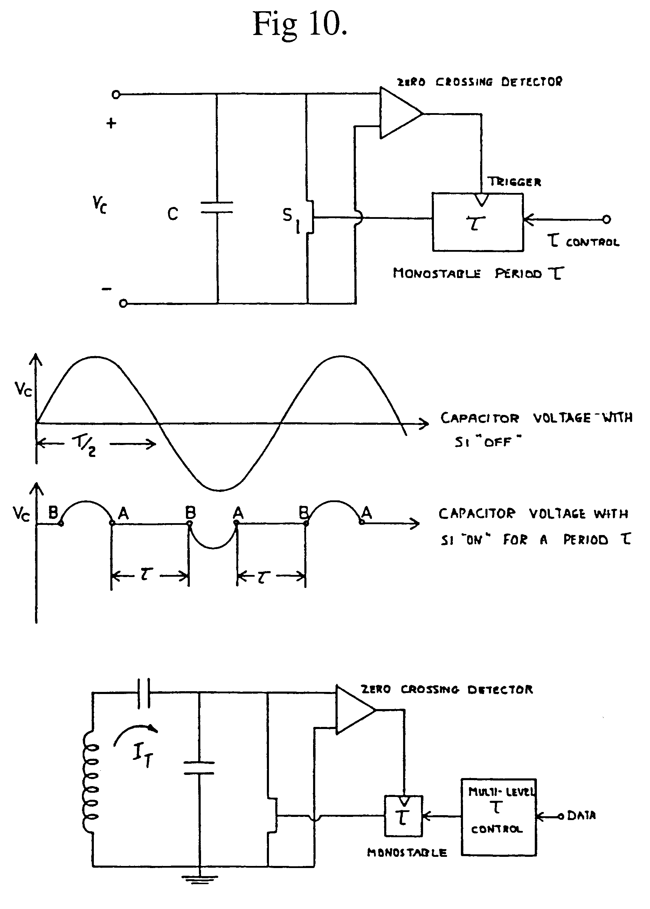

A single variable capacitor may be used to control the current's phase angle and magnitude (the phase angle and amplitude being related). However, typical electronic variable capacitors (varactors) are only capable of handling a few volts of signal and are completely useless for high power/voltage systems. Thus, as an exemplary application, the electronically variable capacitor may be utilized for tuning an interrogator antenna during FSK' ing of a powering field and may be advantageously used in a transponder. The variable reactance together with typical waveforms and an exemplary transponder is shown in Figure 10.

The switch $S_1$ shorts out capacitor C periodically during each cycle. Ideally $S_1$ is a bi-directional switch with zero impedance when closed (ON) and infinite impedance when open (OFF). Such a switch can practically be realised using FET or MOSFET transistors. The switch only opens or closes when the voltage across the capacitor is zero. The time that $S_1$ remains closed $\tau$ is controlled by a monostable. The effective capacitance value $C_{eff}$ is increased by this scheme and varies from $C_{eff} = C$ at $\tau = O$ to $C_{eff} = CO$ when $\tau = T/2$. Where $C_{eff}$ is measured by the fundamental component of voltage across the capacitor switch combination. By controlling $\tau$ with a data signal the data signal can be modulated onto the tuned coil's current phase angle. Control of the phase angle through $\tau$ is a continuously variable monotonic function. Multi-level data can be modulated onto the current phase angle by correctly choosing multi-level values for $\tau$. The circuit can also serve to tune the transponder tuned coil when first installed. The quiescent value of $\tau$ can be set-up to correctly tune the tuned coil. When $\tau$ is varied (by data for example) the circuit will take time to settle at its new operating point. This transient time is roughly $1/(\Pi \times \text{Bandwidth Tuned Circuit})$.

MOSFET transistors normally contain a body diode. The diode rectifies the waveform and introduces a dc bias across the capacitor. When the capacitance is changed (by vary $\tau$) the dc level shifts and will take time to settle. Thus settling time is of the order of $(1/\Pi \times \text{Bandwidth})$. By connecting a p-channel and an n-channel MOSFET transistor in series to implement the bidirectional switch this rectification does not occur. Special gate drive circuitry would be needed to correctly switch the MOSFETS. Figure 24 shows this combination of MOSFETS.

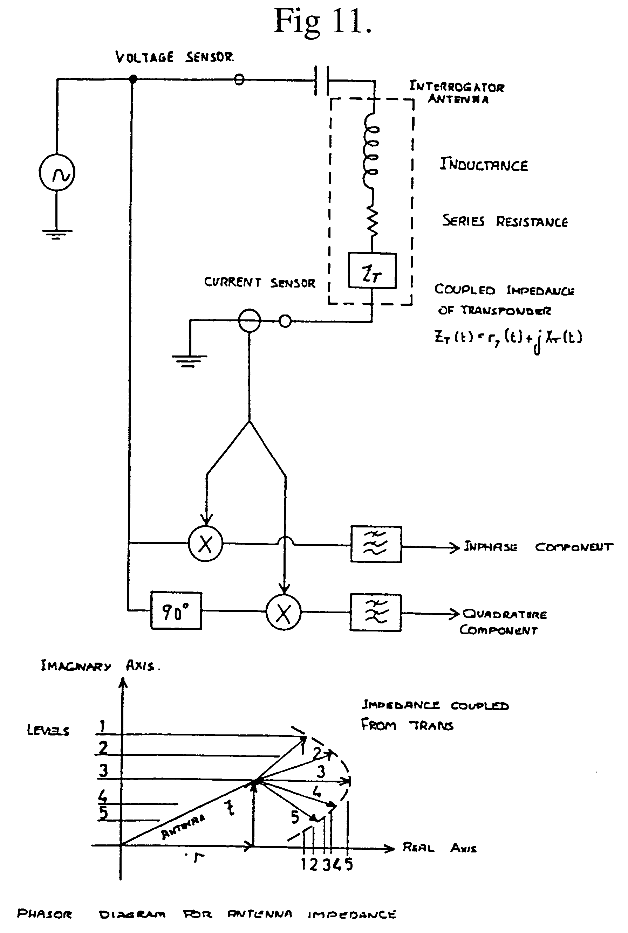

Detection of a phase angle modulated current in a transponder is effected by monitoring the in-phase and quadrature current or voltage components in the interrogators antenna. The choice depends upon the impedance of the antenna's signal source. A voltage source requires current sensing and a current source voltage sensing. Figure 11 shows a circuit for detecting the in-phase and quadrature coupling from a transponder and a phaser diagram for an antenna impedance. Notice that the reactive or quadrature vector monotonically changes with phase angle whereas the real or in-phase component is not a monotonic function of phase angle. The quadrature component can be decoded to reconstruct the multi-level data. The in-phase component can still be used for decoding purposes to improve the overall accuracy by defining a two dimension vector point rather than a line in the decoding space.

An interrogator antenna may be preferentially tuned to operate efficiently and/or to match its electrical parameters to the signal source. As already outlined, tuning is preferably done with the variable reactance detailed above and shown in Figures 1, 10 and 12.

This variable reactance (capacitor) is connected in series with the tuned antenna in this embodiment. Correct tuning is normally defined as the maintenance of a constant, pre-defined, phase angle between the current and voltage into the tuned element. In this case, proper tuning relies upon the maintenance of a residual impedance angle (typically 32°) in the interrogator antenna. The transponder's coupled impedance adds to and alters the total antenna impedance. Under most conditions the impedance angle will be changed and the variable reactance will compensate for the transponder impedance re-establishing the proper residual phase angle. By monitoring the variable reactance, the transponders data can be decoded. Figure 13 shows a block schematic, a circuit diagram and a phasor diagram of this type of system. An added advantage of this system is that it is always substantially perfectly tuned. Once again the information from the in-phase component can be augmented for decoding with the variable capacitor signal and/or with the quadrature component.

An example application, in which three tuned coils are delivering/generating magnetic fields in the three geometric directions, is an interrogator for baggage identification tags on a conveyor system (see U.S. Patent No. 5,258,766). Each coil is tuned at or near the frequency of operation.

As tags are passed through the coils they are programmed by frequency shift keying the magnetic fields. For efficient operation the coils have high Q's and are normally not amenable to FSK modulation, however if they are actively tuned using variable reactance(s) then they may be relatively instantaneously returned to the instantaneous frequency of the FSK signal.

Moreover as metal objects pass through the coils, the tuning will be changed. Thus, the resonant frequency must be adaptively altered as the coils are operated.

**Claims**

1. A device adapted to adjust reactance of an in circuit element, said device comprising a tuning means exhibiting a non-linear VI characteristic electrically coupled to said circuit element.

2. A variable reactance device comprising:
   a reactance element; and

truncating means coupled to said reactance element, said truncating means serving to effect voltage or current conditions associated with the reactance element.

3. A tuning device adapted for use in relatively high current/voltage tuned circuits and adapted to provide an adjustable reactance value, said value being adjustable by truncation of voltage across or current in a reactance element.

4. A device as claimed in claim 3, wherein the value is duty cycle controlled.

5. A device as claimed in claim 2 or 3, wherein the truncating of voltage or current occurs in at least one portion of a cycle.

6. An element as claimed in claim 3 or 4, wherein the value is increased.

7. An element as claimed in claim 3 or 4, wherein the value is decreased.

8. A device as claimed in claim 2 or 3, wherein the truncation means is a switch.

9. A device as claimed in claim 2 or 3, wherein the truncation means is a magnetic core adapted to receive a signal for determining the onset of saturation.

10. A device as claimed in claim 8, wherein the reactance is a capacitance.

11. A device as claimed in claim 9, wherein the reactance is an inductance.

12. A method of providing a reactance of variable value in circuit, comprising truncating voltage across or current in the reactance in at least one portion of a signal cycle.

# Fig 1.

DRIVER COIL

SATURABLE
REACTOR.

# Fig 2.

DRIVER COIL

ELECTRONIC
SWITCH

# Fig 3.

TUNED COIL

CURRENT SENSOR

ZERO CROSSING DETECTOR

Q D

O DATA

STEP INDUCTANCE CHANGE WHEN CURRENT EQUALS ZERO

# Fig 4.

ZERO CROSSING DETECTOR.

TUNED COIL

VOLTAGE SENSOR

Q D

O DATA

MONOSTABLES

CURRENT SENSOR.

$V_C$

PICK UP COIL

$C_1$    $C_2$

$S_1$    $S_2$

$T_1$

$T_2$

TURN OFF BOTH 1+2

TURN ON SWITCH 2

TURN ON SWITCH 1

TO CONTROL LOGIC

TO CONTROL LOGIC

## Fig 5.

IMAGINARY AXIS

$(c_1)_{I_1}$

I (QUADRATURE)

I (INPHASE)

REAL AXIS

$(c_2)_{I_2}$

I (QUADRATURE)

I

PHASOR DIAGRAM OF $I_L$ FOR $C_1$ AND $C_2$ IN CIRCUIT

# Fig 6.

# Fig 7

## Fig 8.

CORNET
CAPACITOR VALUE FOR RESORNANCE

ENHANCEMENT TRANSISTOR NORMALLY
REQUIRES VOLTAGE TO TURN OFF.

PICKUP COIL

$C_1$  $C_2$  $C_p$  $C_{n-1}$  $C_n$

CURRENT
SENSOR.

TO LOGIL TO GENERATE PROPER
N-LEVEL SIGNALS AND TIMING

FIGURE 20

## Fig9.

PICKUP COIL

$I_L$

$S_1$  $S_2$

TO CONTROL LOGIC

IMAGINARY AXIS

(0,1)

REAL AXIS

(0,0)

(1,0)

PHASOR DIAGRAM OF $I_b$
($S_1$ STATE, $S_2$ STATE)
0 = OFF , 1 = ON

# Fig 10.

ZERO CROSSING DETECTOR

$V_C$

C

$S_1$

TRIGGER

$\tau$

$\tau$ CONTROL

MONOSTABLE PERIOD $\tau$

$V_C$

$T/2$

CAPACITOR VOLTAGE WITH $S_1$ "OFF"

$V_C$  B  A  B  A  B  A

$\tau$  $\tau$

CAPACITOR VOLTAGE WITH $S_1$ "ON" FOR A PERIOD $\tau$

ZERO CROSSING DETECTOR

$I_T$

MULTI-LEVEL $\tau$ CONTROL

DATA

$\tau$

MONOSTABLE

# Fig 11.

VOLTAGE SENSOR.

INTERROGATOR ANTENNA

INDUCTANCE

SERIES RESISTANCE

$Z_T$

CURRENT SENSOR

COUPLED IMPEDANCE OF TRANSPONDER

$$Z_T(t) = r_T(t) + j X_T(t)$$

90°

INPHASE COMPONENT

QUADRATURE COMPONENT

IMAGINARY AXIS.

IMPEDANCE COUPLED FROM TRANS

LEVELS

1
2
3
4
5

2
3
4
5

ANTENNA $Z$

·r

REAL AXIS

1 2 3 4 5

PHASOR DIAGRAM FOR ANTENNA IMPEDANCE

# Fig 12.

ZERO CROSSING DETECTOR

D

G

S

D

G

GATE DRIVE CIRCUITS

DATA

# Fig 12.

PHASE ANGLE DETECTOR

ANTENNA

CONTROL

VARIABLE CAPACITOR

DEMODULATE FOR DATA

PRESET PHASE ANGLE

τ CONTROL

DECODE

IMAGINORY AXIS

TUNER COMPENSATION

PRESET PHASE ANGLE

TUNER COMPENSATION

Θ ANTENNA Z

REAL AXIS